Europäisches Patentamt

European Patent Office

Office européen des brevets

(11) Publication number: **0 186 469**
**A2**

## (12) EUROPEAN PATENT APPLICATION

(21) Application number: 85309336.7

(51) Int. Cl.⁴: **H 03 K 19/177**

(22) Date of filing: 20.12.85

(30) Priority: 21.12.84 GB 8432553

(43) Date of publication of application:
02.07.86 Bulletin 86/27

(84) Designated Contracting States:
BE DE FR IT LU NL SE

(71) Applicant: PLESSEY OVERSEAS LIMITED
Vicarage Lane
Ilford Essex IGl 4AQ(GB)

(72) Inventor: Ettinger, George Michael, Dr.
36 Huntly Road Talbot Woods
Bournemouth Dorset BH3 7HM(GB)

(72) Inventor: Tillier, Michael Leslie
93 Harewood Avenue
Bournemouth Dorset BH7 6NN(GB)

(74) Representative: Sorenti, Gino
Intellectual Property Department The Plessey Company
plc 2-60 Vicarage Lane
Ilford Essex IG1 4AQ(GB)

(54) Logic devices.

(57) A logic circuit comprising a programmed memory device
(7) which has one or more data outputs (D0–D2) cross-
connected to one or more corresponding address inputs
(A2–A4), data programmed in the memory (7) is arranged to
cause the memory device (7) to self-address through at least
one transient state before taking up a stable state. Inclusion
of a delay (6) in a cross connection lengthens the period of
the transient state. The specification discloses logic devices
having cross-connected outputs and inputs and adapted for
use as logic gates, pattern generators, oscillators and
frequency dividers.

EP 0 186 469 A2

## LOGIC DEVICES

The present invention relates to logic devices and more particularly to logic devices implemented in programmable memory devices.

Because of diversity of types of integrated circuit logic devices currently available a circuit designer is faced with a major problem in deciding which device should be used. Thus before implementing a circuit several "chip" types must be considered none of which may be exactly what is required. Thus one "chip" may have a logic gate spare and an adder too few whilst another "chip" may have an adder too many and a logic gate too few.

Consequently the circuit designer may have to put in an additional "chip" to make up the shortfall. The more diverse the circuit function is, the more likely it is that additional "chips" will have to be used and the more integrated circuit packages that need to be interconnected, the more difficult it will be to lay out a printed circuit board with inter-connections to accomodate the packages.

Some attempts have been made to overcome this problem by providing integrated circuit packages in the form of uncommitted logic arrays sometimes known as programmable logic arrays.

A programmable logic array (PLA) is programmed by blowing fuse links in the device to provide its "personality". Once programmed the device retains its personality in perpetuity. Accordingly if an error is made in an initial circuit design or during programming of the PLA, the component is of no further use. It will also be appreciated that when a circuit is completed it may include a multiplicity of PLAs each individually programmed for a specific task leading to a similar diversity in stock requirements as occurs with other integrated circuit package devices.

It is an object of the present invention to provide a family of logic devices implemented in programmable random access memories or programmable read-only memories.

According to one aspect of the present invention there is provided a logic circuit comprising a programmed memory device which has at least one data output which is cross-connected to at least one address input of the device and at least a part of data programmed in the device is arranged to cause on addressing output on a cross-connected data output of an output signal of opposite binary value to the binary value of an initially present input signal to effect a change in said address signal whereby the device passes through at least one self-generated transient state to take up a predetermined logical value on at least one data output.

Preferably the device has at least one other data output and bits which on addressing of the data are output thereon are freely programmable to provide a required output signal in a transient or stable state of the device.

A delay may be provided in the cross-connection whereby the time of the transient state of the device is lengthened.

A plurality of cross-connections between different data outputs of the device and a plurality of the address inputs may be provided, data being programmed in the device being arranged to cause a sequence of self-generated addresses to be applied to the address inputs.

According to a second aspect of the present invention there is provided an oscillator comprising a memory device which has at least one data output which is cross-connected to at least one address input of the device, data programmed in the device being arranged on being addressed by a first address value to cause output of a signal having a second address value on said cross-connected data output and on being addressed by the second address value to cause output of a signal having the first address value on said cross-connected data output whereby the output signal oscillates between said first and second address values.

A tuneable delay which may comprise a resistor and capacitor (RC) network may be provided in said cross-connection to allow tuning of the frequency of oscillation.

Logic devices in accordance with the various aspects of the invention will now be described by way of example only with reference to the accompanying drawings of which:-

Figure 1 is a schematic representation of an implementation of an AND gate with a feedback loop;

Figure 2 is a schematic representation of an implementation of a logic circuit including a short delay;

Figure 3 is a schematic representation of an implementation of a logic circuit having a longer delay;

Figure 4 is a schematic representation of a memory device used as a free-running oscillator;

Figure 5 is a schematic representation of a frequency controllable oscillator using a memory device;

Figure 6 is a schematic representation of an oscillator and divider arrangement using a memory device;

Figure 7 is a graphic representation of the outputs of the arrangement of Figure 6;

Figure 8 is an interconnection diagram showing a plurality of memory devices in use as a pattern generator or divider; and

Figure 9 shows a graphic comparison of the capabilities of a single memory device and the arrangement of Figure 8.

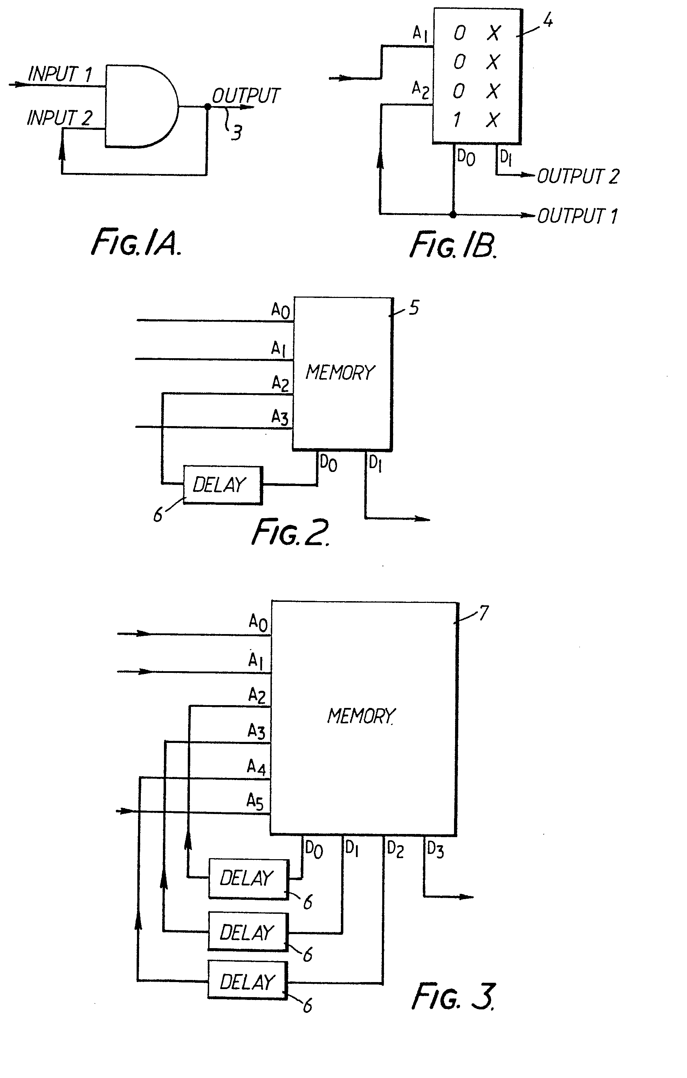

Referring first to Figure 1, Figure 1A shows a logic AND gate with feedback from an output 3 to input 2. The gate of Figure 1A is shown as representative of a family of prior art devices including NAND gates, OR, NOR and exclusive OR gates. Memories of both random access (RAM) or read only (ROM) type exhibit essentially combinational logic transfer characteristics after inherent internal delays and it is known that sequential logic characteristics can be created by suitable feedback links.

Thus in Figure 1B a RAM or ROM 3 is shown which performs the same function as the gate of Figure 1A. Thus consider the following truth tables for each of the devices:-

AND gate

| INPUT (1) | FEEDBACK(INPUT 2) | OUTPUT(3) | DEVICE STATE |
|---|---|---|---|
| 1 | 1 | 1 | Stable |
| 0 | 1 | 0 | Transient |
| 0 | 0 | 0 | Stable |
| 1 | 0 | 0 | Stable |

Memory 4

| INPUT(A1) | FEEDBACK(INPUT A2) | OUTPUT(DO) | DEVICE STATE |
|-----------|--------------------|-----------|--------------|
| 1 | 1 | 1 | Stable |
| 0 | 1 | 0 | Transient |
| 0 | 0 | 0 | Stable |
| 1 | 0 | 0 | Stable |

It will be noted that the two tables are identical. In both cases it would be necessary to apply a binary 'one' signal to the second input (2 or A2) to "start" the sequence.

Thus application of a binary 1 to the input 2 (or A2) and a binary '1' to the input 1 (or A1) cause a '1' output on 3 (or Do). The '1' input is fed back to the input 2 (or A2) to provide a holding signal so that as long as the '1' input continues to be present at the input 1 (or A1) the output is stable at '1'.

When the signal applied to input 1 or A1 changes to a binary '0' value in the case of the gate (Figure 1A) the '1' output continues to be present for a finite period. Hence the input 2 continues to receive a '1' input signal for that period and the gate is in a transient state. Once the output returns to '0' the input 2 returns to '0' and the gate enters a stable condition.

-7-

Bits of the words which bits are output on Do when the memory 4 is addressed by address inputs having values '00', '01', '10' and '11' are respectively '0','0','0' and '1'. Thus a similar finite delay is present between the change of signal in the input Al (that is from addressing with '11' to addressing with '01') and the stable state with an address '00'.

Other bits in the addressed words are available to provide other outputs for example on output Dl which is a freely programmable line. Thus the output Dl may be programmed to produce a transient pulse signal in the period in which the device is in a transient state between address '01' and address '00' for example.

Turning now to Figure 2 a memory 5 having four address inputs Ao-A3 and two data outputs Do, Dl is programmed in accordance with the following truth table:-

| Address | | | | Data | |
|---|---|---|---|---|---|
| Ao | Al | A2 | A3 | Do | Dl |
| 0 | 0 | 0 | 0 | 0 | Any |
| 1 | 0 | 0 | 0 | 0 | Any |
| 0 | 1 | 0 | 0 | 0 | Any |
| 1 | 1 | 0 | 0 | 1 | Any (TRANSIENT STATE) |
| 1 | 1 | 1 | 0 | 1 | Any |
| 0 | 0 | 1 | 1 | 1 | Any |
| 1 | 0 | 1 | 1 | 1 | Any |

It will be noted that the first 3 and last 3 lines of the truth table show that the memory 5 will exhibit conbinational logic characteristics. However, when addressed with '0011', the memory enters a transient state since the output Do provides a '1' signal to the input A2. This output signal is of opposite value to the address input signal present on A2 and will cause the next word ('0111') to be addressed. Thus the output D1 which is freely programmable outputs the value stored at address '0011' for a finite period in dependence upon the period taken for the output signal on output Do to reach the input A2.

If a delay 6 is interposed in the connection from Do to A2 the transient state may be maintained for any desired period. The delay 6 may be a delay line or a buffered resistor/capacitor (RC) time constant or may be a further device delay (the delay time of the memory itself) as explained hereinafter with reference to Figure 3. Alternatively the delay 6 may be a frequency determining network including a crystal.

Thus referring to Figure 3 three outputs Do-D2 are cross-connected to respective inputs A2-A4 of a memory 7. Address inputs Ao, A1, A5 are again available for connection to other signal circuits and a freely programmable output D3 is also available.

It is here noted that more than one freely programmable data output may be left available and that any number of address inputs may similarly be available for connection to other signal providing devices. It will be appreciated that whenever the memory 7 receives an address which causes one or more of the outputs $D_0-D_2$ to output a signal whose binary value is opposite to the binary value currently present on the cross-connected inputs $A_2-A_4$ the memory enters a transient state. The memory 7 will remain in a transient state until such time as the output value on $D_0-D_2$ equals the address value on $A_3-A_5$.

Ignoring the address inputs $A_0, A_1$ and $A_5$ and the output $D_3$ which is freely programmable, consider the following truth table for the memory 7 which for purposes of subsequent description carries letter references

| Reference | A2 | A3 | A4 | Do | D1 | D2 | Condition |
|-----------|----|----|----|----|----|----|-----------|
| S | 0 | 0 | 0 | 1 | 0 | 0 | Transient |
| T | 1 | 0 | 0 | 0 | 1 | 0 | Transient |
| U | 0 | 1 | 0 | 1 | 1 | 0 | Transient |
| V | 1 | 1 | 0 | 0 | 0 | 1 | Transient |
| W | 0 | 0 | 1 | 1 | 0 | 1 | Transient |
| X | 1 | 0 | 1 | 0 | 1 | 1 | Transient |
| Y | 0 | 1 | 1 | 1 | 1 | 1 | Transient |
| Z | 1 | 1 | 1 | 1 | 1 | 1 | Stable |

From Figure 3 it will be seen that output Do is connected to the input A2, D1 to A3 and D2 to A4 each by way of a respective delay 6. If now the above truth table is considered as an addressable block within the memory say commencing when inputs Ao, Al and A5 are all at value '0', the addressed words for the block are:-

(S)000000, (T)001000, (U)000100, (V)001100,

(W)000010, (X)001010, (Y)000110, (Z)001110.

If applied signals at Ao, Al and A5 remain stable for the duration of the accumulated delays introduced then on address 'S' address 'T' is fed back via the delay 6. After the delay 6 address 'T' causes address 'U' to be output which is fed back via the respective delay 6 and so on to address 'Z' which causes output of its own address causing the memory to enter a stable condition.

Since the output D3 is freely programmable it may be programmed to output, say, a single pulse value of '1' for a time of seven "delays" followed by returning to a stable value of '0' at Z. Alternatively D3 could be arranged to produce a series of pulses through the delay period by programming alternate '0' and '1' values or may simply be a delay in the effective change of state of the output. It will be appreciated that if further freely programmable outputs are required an eight bit or wider memory may be used in place of the four bit memory 7 shown in Figure 3.

If a shorter delay period is required, it will be realised that at, say, 'V' outputs Do, D1 and D2 may be programmed to output "110" to cause the memory to enter a stable state at that point.

Further blocks of programme S to Z may be entered anywhere in the memory. For example if a change from the inputs Ao, A1, A5 all '0' values change with say the input A5 receiving a '1' then a further block commencing at address "000001" may be entered as follows:-

|      | (Ao) | (A1) | A2 | A3 | A44 | (A5) | Do | D1 | D2 |                |
|------|------|------|----|----|-----|------|----|----|----|----------------|
| S'   | (0   | 0)   | 0  | 0  | 0   | (1)  | 1  | 0  | 0  |                |
| T'   | (0   | 0)   | 1  | 0  | 0   | (1)  | 0  | 1  | 0  |                |
| U'   | (0   | 0)   | 0  | 1  | 0   | (1)  | 1  | 1  | 0  |                |
| V'   | (0   | 0)   | 1  | 1  | 0   | (1)  | 0  | 0  | 1  |                |
| W'   | (0   | 0)   | 0  | 0  | 1   | (1)  | 1  | 0  | 1  |                |
| X'   | (0   | 0)   | 1  | 0  | 1   | (1)  | 0  | 1  | 1  |                |
| Y'   | (0   | 0)   | 0  | 1  | 1   | (1)  | 0  | 0  | 1  | (Stable State) |
| Z'   | (0   | 0)   | 1  | 1  | 1   | (1)  | 0  | 0  | 0  |                |

It will be noted that in this case the change of input A5 from value '0' to value '1' will cause the address to change to Z' (since Do, D1, D2 are at 111 from the previous stable state therefore the inputs A2, A3, A4 are at value '111') and in this case the stable state is shown as being at Y'.

It will be appreciated from the ability of the memory 7 to reflect changes in received logic signals by providing (eg) a pulse output or a delayed change that

0186469

-12-

the arrangement shown will find use in many circuit applications.

One specific example of a use is in a "handshake" arrangement in which communicating devices require to follow a "setup" protocol before one or other commences data transmission. The address of a memory device may be connected to appropriate signal sources indicating for example the readiness of the communicating receiver to accept signals on data bus, the availability of the data bus and seize signals from the communicating transmitter. One or more outputs of the memory may now be used to return signals in dependence upon the protocol requirements, the signals being pulsed, or delayed in the manner indicated above.

Thus in any circuit where a control signal interchange is required a memory such as a read-only-memory (ROM), or random access memory (RAM) may be used to control signal flow. One particular advantage of using a programmable memory will now be apparent. If for example a PROM or EPROM is used any change in the protocol may be reflected by reprogramming quickly and effectively with no requirement for major circuit changes and no wastage of the circuit components.

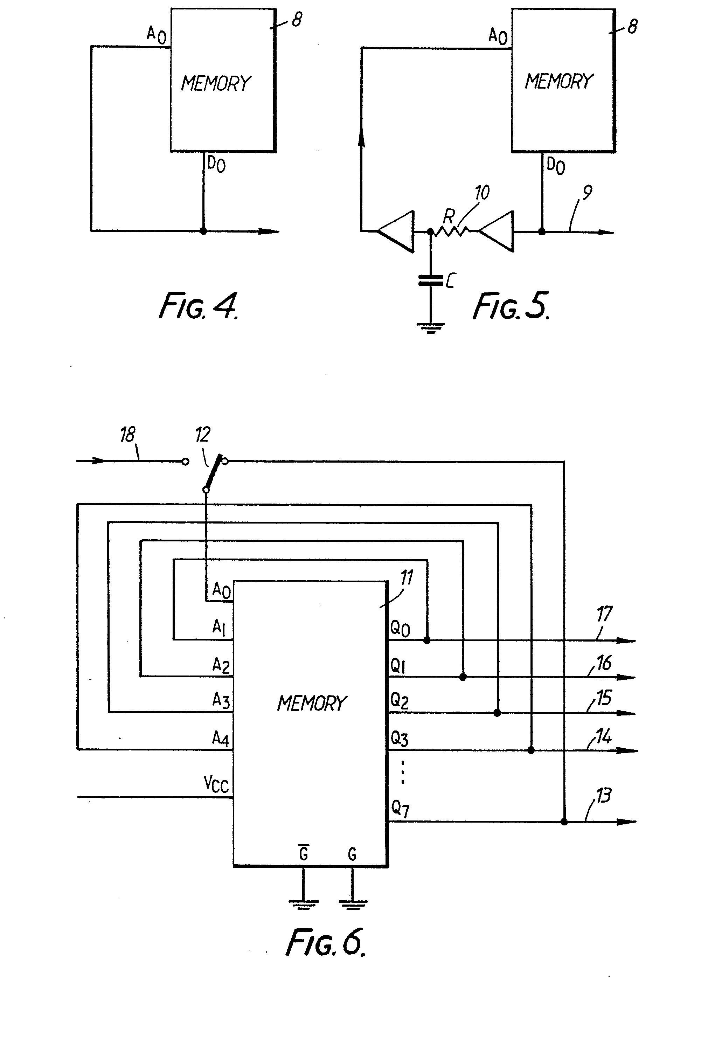

Referring now to Figure 4 the invention may be used to provide an effective oscillator by maintaining a memory 8 in a permanent transient state.

If for example, when the input Ao is at value '0' the addressed word outputs a '1' on the output Do and when the input Ao is at '1' the addressed word outputs a '0' on the output Do, an output 9 provides an oscillating signal at a speed determined by the inherent characteristics of the memory 8. By experiment a typical memory oscillates at a frequency of approximately nine megaherz.

By causing the memory 8 to oscillate it is possible to test any memory for device speed simply by connecting an oscilloscope or digital timer. Exceptionally slow or exceptionally fast devices may then be selected from a set of devices. Testing across a range of input addresses may be carried out by looping back an output to different inputs and programming the memory accordingly.

A more practical oscillator is shown in Figure 5 to which reference is now made in which the looped back signal is delayed by an "RC" network 10. In this case the output frequency is approximately $\frac{1}{RC}$ up to the memory speed and successful tests have been carried out using various resistors and capacitors to give output frequencies in the range one herz to five megaherz.

It will be appreciated that a tuneable RC network may be used to permit a variable frequency oscillation to be provided.

-14-

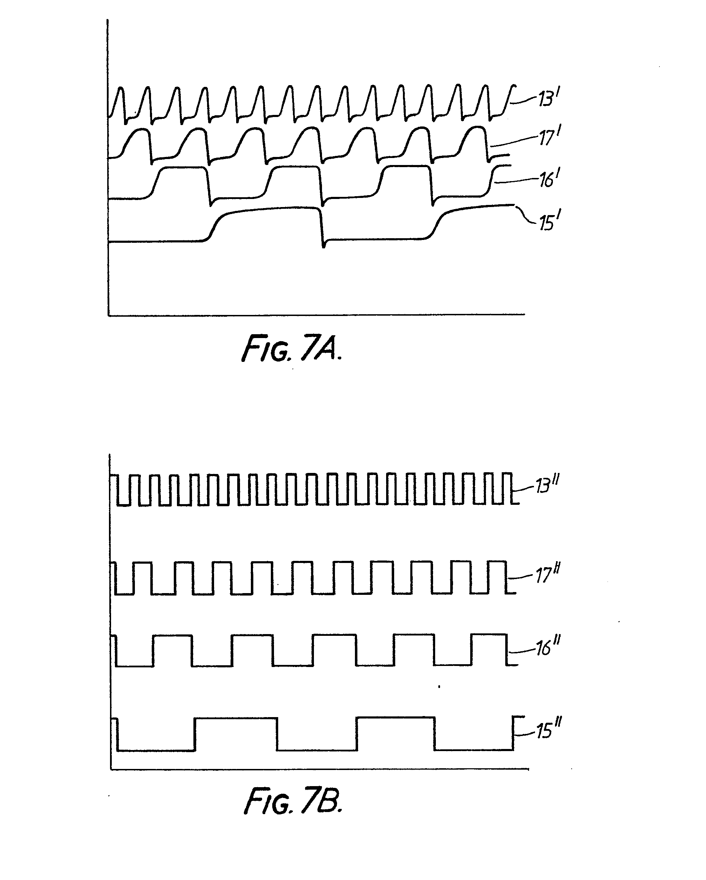

Reference will now be made to Figure 6 in which an oscillator and/or frequency devider circuit using a memory 11 is shown.

The memory 11 is programmed according to the following truth table:-

| A4 | A3 | A2 | A1 | Ao | Q7 | (Q6 | Q5 | Q4) | Q3 | Q2 | Q1 | Qo |
|----|----|----|----|----|----|-----|----|-----|----|----|----|----|
| 0 | 0 | 0 | 0 | 0 | 1 | | | | 0 | 0 | 0 | 0 |
| 0 | 0 | 0 | 0 | 1 | 1 | | | | 0 | 0 | 0 | 1 |
| 0 | 0 | 0 | 1 | 1 | 0 | | | | 0 | 0 | 0 | 1 |
| 0 | 0 | 0 | 1 | 0 | 0 | | | | 0 | 0 | 1 | 0 |
| 0 | 0 | 1 | 0 | 0 | 1 | | | | 0 | 0 | 1 | 0 |
| 0 | 0 | 1 | 0 | 1 | 1 | | | | 0 | 0 | 1 | 1 |
| 0 | 0 | 1 | 1 | 1 | 0 | | | | 0 | 0 | 1 | 1 |
| 0 | 0 | 1 | 1 | 0 | 0 | | | | 0 | 1 | 0 | 0 |
| 0 | 1 | 0 | 0 | 0 | 1 | | | | 0 | 1 | 0 | 0 |
| 0 | 1 | 0 | 0 | 1 | 1 | | | | 0 | 1 | 0 | 1 |
| 0 | 1 | 0 | 1 | 1 | 0 | | | | 0 | 1 | 0 | 1 |
| 0 | 1 | 0 | 1 | 0 | 0 | | | | 0 | 1 | 1 | 0 |
| 0 | 1 | 1 | 0 | 0 | 1 | | | | 0 | 1 | 1 | 0 |
| 0 | 1 | 1 | 0 | 1 | 1 | | | | 0 | 1 | 1 | 1 |
| 0 | 1 | 1 | 1 | 1 | 0 | | | | 0 | 1 | 1 | 1 |
| 0 | 1 | 1 | 1 | 0 | 0 | | | | 1 | 0 | 0 | 0 |
| 1 | 0 | 0 | 0 | 0 | 1 | | | | 1 | 0 | 0 | 0 |
| 1 | 0 | 0 | 0 | 1 | 1 | | | | 1 | 0 | 0 | 1 |
| 1 | 0 | 0 | 1 | 1 | 0 | | | | 1 | 0 | 0 | 1 |
| 1 | 0 | 0 | 1 | 0 | 0 | | | | 1 | 0 | 1 | 0 |
| 1 | 0 | 1 | 0 | 0 | 1 | | | | 1 | 0 | 1 | 0 |
| 1 | 0 | 1 | 0 | 1 | 1 | | | | 1 | 0 | 1 | 1 |
| 1 | 0 | 1 | 1 | 1 | 0 | | | | 1 | 0 | 1 | 1 |
| 1 | 0 | 1 | 1 | 0 | 0 | | | | 1 | 1 | 0 | 0 |
| 1 | 1 | 0 | 0 | 0 | 1 | | | | 1 | 1 | 0 | 0 |
| 1 | 1 | 0 | 0 | 1 | 1 | | | | 1 | 1 | 0 | 1 |
| 1 | 1 | 0 | 1 | 1 | 0 | | | | 1 | 1 | 0 | 1 |
| 1 | 1 | 0 | 1 | 0 | 0 | | | | 1 | 1 | 1 | 0 |
| 1 | 1 | 1 | 0 | 0 | 1 | | | | 1 | 1 | 1 | 0 |
| 1 | 1 | 1 | 0 | 1 | 1 | | | | 1 | 1 | 1 | 1 |
| 1 | 1 | 1 | 1 | 1 | 0 | | | | 1 | 1 | 1 | 1 |
| 1 | 1 | 1 | 1 | 0 | 0 | | | | 0 | 0 | 0 | 0 |

Outputs Q6, Q5 and Q4 of the memory 11 are freely programmable to produce any desired pattern output.

Considering first the operation of the memory 11 as a self controlled oscillator a switch 12 is set to connect output Q7 to the input Ao which puts the memory 11 into a "permanent" transient state. As in the case of the Figure 4 and Figure 5 oscillators the device now oscillates at the device speed although if desired a delay (not shown) could be inserted in the Q7-Ao feedback path.

The oscillating signal from the output Q7 may be taken from an output lead 13. As the addresses on inputs Ao to A4 are stepped through due to the feedback connections provided Qo will provide an oscillating signal at half the frequency of Q7 at output 17, Q1 at one quarter the frequency of Q7 at output 16, Q2 at one eighth the frequency and Q3 at one-sixteenth the frequency of Q7 at outputs 15 and 14 respectively.

Whilst only division by powers of two is shown in the table above it will be appreciated that other division ratios may be used by programming of the outputs Q4-Q6 to produce appropriate patterns approximating to other desired frequency outputs.

A reproduction of an oscilloscope trace of the outputs Q7, Qo, Q1 and Q2 is shown in Figure 7A to which reference is also made. In a practical test the respective outputs were at nine, four and half, two and a quarter and one and one eighth megahertz respectively for output leads 13, 17, 16 and 15 respectively, the signals being designated by the output lead reference modified by a prime mark.

Referring again to Figure 6, if now the switch 12 is turned to the other position (disabling the feedback from Q7 to Ao) and a rectangular wave input signal is applied to an input 18 and thence to the input Ao of the memory 11, the memory acts solely as a frequency divider. The output Q7 will provide an output signal corresponding in frequency to the input signal with the other outputs Qo-Q3 providing output signals divided in frequency as before.

In Figure 7B an oscilloscope trace is reproduced for the memory 11 when driven with a one kilohertz square-wave signal to provide outputs of one kilohertz, 500 hertz, 250 hertz and 125 hertz respectively on the leads 13, 17, 16 and 15 as indicated in the drawing by the corresponding reference number marked with a double prime.

Again other divisions may be used by programming of the outputs Q4-Q6 and, if the memory 11 is not required to operate in a self-oscillating mode the output Q7 is also available for free programming.

-18-

As the memory size increases towards 2048(2K) bits the number of data output lines (commonly eight in SRAM or PROM devices) is insufficient to allow the number of feedback loops to give a long pattern on the output lines or a division ratio greater than $2^6$.

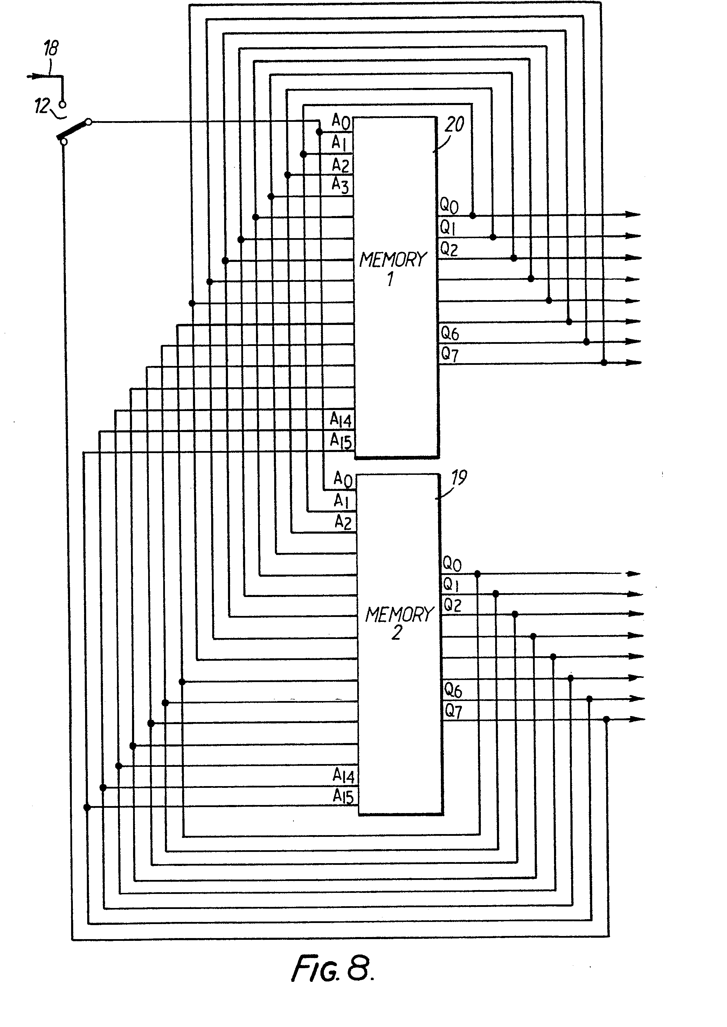

Accordingly, referring to Figure 8, the invention proposes that two (or more if needed) memories 19, 20 be interconnected. Thus address inputs Ao-A15 are connected in parallel and eight data outputs Qo-Q7 of the memory 20 are looped back to address inputs A1-A8 whilst outputs Qo-Q6 of the memory 19 are looped back to address inputs A9-A15.

Output Q7 of the memory 19 is looped back to address input Ao of memory 20 via the switch 12 so that the device may be used in the self oscillating mode or as a divider of an input frequency supplied on the input 18 in the same manner as for the oscillator/divider arrangement hereinbefore described with reference to Figure 6.

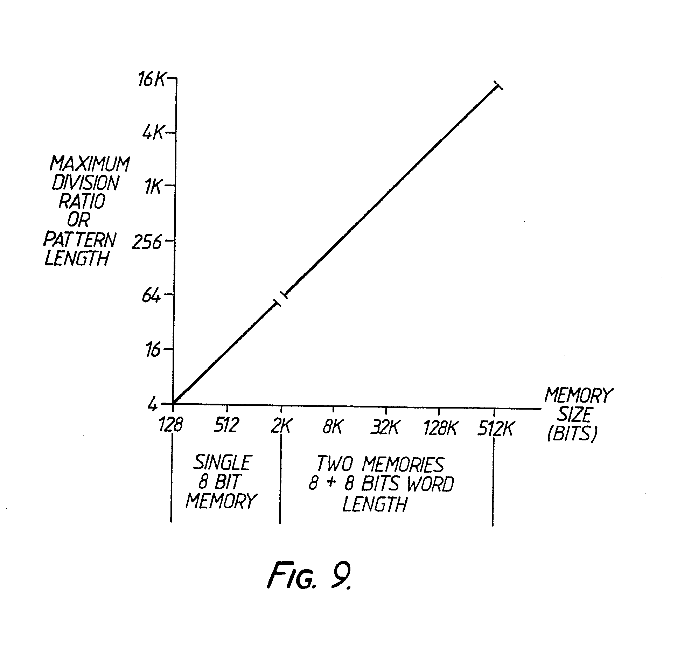

The capability of memories connected in parallel is shown in Figure 9 from which it may be seen that adding one memory in parallel with another greatly enhances the pattern length or maximum division ratio which may be achieved.

In the arrangements disclosed hereinbefore memory useage for devices having size ranges of from 64 bits to 512 K bits have the following capabilities where:-
N represents the number of feedback lines, n is the
maximum division ratio (in bits), L is the pattern length
(in bits) and F represents the number of outputs
available for free-programming:-

Single "8 bit" Memory.

| Memory Size | Address Length | N | n | L | F |
|---|---|---|---|---|---|
| 64 bits | 8 | 3 | 1 | 2 | 5 |
| 128 bits | 16 | 4 | 2 | 4 | 4 |
| 256 bits | 32 | 5 | 3 | 8 | 3 |
| 512 bits | 64 | 6 | 4 | 16 | 2 |
| 1 K bit | 128 | 7 | 5 | 32 | 1 |
| 2 K bit | 256 | 8 | 6 | 64 | 0 |

Two "8" bit Memories (16 bits width)

| Memory Size | Address Length | N | n | L | F |
|---|---|---|---|---|---|
| 4 K bit | 512 | 9 | 7 | 128 | 7 |
| 8 K bit | 1K | 10 | 8 | 256 | 6 |
| 16 K bit | 2K | 11 | 9 | 512 | 5 |
| 32 K bit | 4K | 12 | 10 | 1K | 4 |
| 64 K bit | 8K | 13 | 11 | 2K | 3 |
| 128 K bit | 16K | 14 | 12 | 4K | 2 |
| 256 K bit | 32K | 15 | 13 | 8K | 1 |
| 512 K bit | 64K | 16 | 14 | 16K | 0 |

It will be appreciated that if more than the number of freely programmable outputs (F) are required the connection of a further memory in the manner of the Figure 8 inter-connection will provide a further eight freely programmable output lines. No feedback loops from any of the outputs of the further memory would be required.

CLAIMS:-

1. A logic circuit comprising a programmed memory device which has at least one data output (D0) which is cross-connected to at least one address input (A2) of the device characterised in that at least a part of data programmed in the device (4) is arranged to cause on addressing output on a cross-connected data output (D0) of an output signal of opposite binary value to the binary value of an initially present address input signal to effect a change in said address signal whereby the device (4) passes through at least one self-generated transient state to take up a predetermined logical value on at least one data output (D0).

2. A logic circuit according to Claim 1 wherein the device has at least one other data output (D1) and bits which on addressing of the data are output thereon are freely programmable to provide a required output signal in a transient or stable state of the device.

3. A logic circuit according to Claim 1 or Claim 2 wherein a delay (6) is provided in the cross connection between said at least one data output (D0) and said at least one address input (A2) whereby the time of the transient state of the device (4) is lengthened to effect a delay in the output of a required signal.

4.   A logic circuit according to Claim 1, Claim 2 or Claim 3 wherein a plurality of address inputs (A2,A3,A4) of the device are cross-connected to a plurality of data outputs (D0,D1,D2) and data programmed in the device is arranged an addressing to cause a sequence of self-generated addresses to be applied to the address inputs (A2,A3,A4) whereby a series of transient states of the device is provided.

5.   An oscillator comprising a memory device (8) which has at least one data output (D0) which is cross-connected to at least one address input (A0) of the device characterised in that data programmed in the device is arranged on being addressed by a first address value to cause output of a signal having a second address value on said cross-connected data output (D0) and on being addressed by the second address value to cause output of a signal having the first address value on said cross-connected data output (D0) whereby the output signal oscillates between said first and second address values.

6.   An oscillator according to Claim 5 wherein a tuneable delay (10) is provided between said at least one data output (D0) and said at least one address input (A0) whereby tuning of the frequency of oscillation is provided.

7. An oscillator according to Claim 6 wherein said delay (10) comprises a resistor and capacitor (RC) network.

8. An oscillator according to Claim 6 wherein said delay (10) comprises a frequency determining network including a crystal.

9. An oscillator according to any one of Claims 5 to 8 wherein a plurality of data outputs (Q0-Q3) of the memory device are cross-connected to a corresponding plurality of data inputs (A1-A4) of the device (11) and data programmed in the device is arranged on being addressed to cause output of signals on the outputs (Q0-Q3) having frequencies related to the frequency of an applied (18) or self-generated oscillation by an integral number divisor.

10. An oscillator according to any one of Claims 5 to 9 wherein a plurality of memory devices (19,20) each having a plurality of address inputs (A0-A15) and a plurality of data outputs (Q0-Q7) are arranged with address inputs (A0-A15) of one device (19,20) connected to corresponding address inputs (A0-A15) of the other memory device (20,19) and data outputs (Q0-Q7) of one device (20) are cross-connected to a first plurality of the address inputs (A1-A2) of the memory devices (19,20) and data outputs (Q0-Q7) of the other device (19) are cross-

-24-

connected to a second, different, plurality of the address inputs (A0,A9-A15) of the memory devices (19,20) whereby a greater number of related output frequency signals may be generated.

11. An oscillator according to any one of Claims 5 to 10 wherein at least one data bit of each word held in the memory device or devices is freely programmable to permit use of at least one of the data outputs to be used as a pattern generator.

1/5

0186469

Fig.IA.

Fig.IB.

Fig.2.

Fig.3.

2/5

0186469

A₀  MEMORY  8

D₀

**Fig. 4.**

A₀  MEMORY  8

R  10

C

9

D₀

**Fig. 5.**

18  12

A₀
A₁          Q₀    17
A₂          Q₁    16
A₃   MEMORY  Q₂   15
A₄          Q₃    14
Vcc         ⋮
            Q₇    13

11

Ḡ   G

**Fig. 6.**

FIG. 7A.

FIG. 7B.

FIG. 8.

FIG. 9.